# FASCICULE DE BREVET EUROPEEN

(11) **EP 0 589 518 B1**
(45) Date de publication et mention de la délivrance du brevet: **15.07.1998**
(21) Numéro de dépôt: 93202676.8
(22) Date de dépôt: 16.09.1993
(51) Int. Cl.: G01R 31/28, G01R 31/316

(54) **Dispositif de calibrage hyperfréquence**
Anordnung zur Hyperfrequenzeichnung
Appliance for hyperfrequent calibration

(30) Priorité: 23.09.1992 FR 9211332
(43) Date de publication de la demande: 30.03.1994
(73) Titulaire: LABORATOIRES D'ELECTRONIQUE PHILIPS S.A.S., 94450 Limeil-Brévannes (FR); Philips Electronics N.V., 5621 BA Eindhoven (NL)
(72) Inventeur: Walters, Peter, Société Civile S.P.I.D., F-75008 Paris (FR); Gamand, Patrice, Société Civile S.P.I.D., F-75008 Paris (FR)
(74) Mandataire: Lottin, Claudine

(56) Documents cités:
- EP-A- 0 445 928
- PATENT ABSTRACTS OF JAPAN vol. 16, no. 35 (P-1304)(5078) 28 Janvier 1992 & JP-A-32 43 871
- MICROWAVE JOURNAL vol. 28, no. 1, Janvier 1985, MASSACHUSETTS,US pages 121 - 129,CARLTON:'microwave wafer probing'

## Description

L'invention concerne un dispositif de calibrage pour ajuster en hyperfréquences les plans de référence d'un appareillage de mesure des paramètres de dispersion d'éléments de circuit intégrés sur un substrat, ce dispositif comprenant, intégrés sur ce même substrat des motifs standards et des accès à ces motifs compatibles avec les contacts de deux sondes de test connectées à l'appareillage.

L'invention trouve son application dans la technologie des circuits intégrés monolithiques (MMICs en anglais) fonctionnant en hyperfréquences entre 40 et 80 GHz, par exemple autour de 60 GHz, et du type dit microruban.

Par technologie microruban, il faut entendre un type dans lequel les circuits intégrés sont réalisés sur un substrat dont une première face reçoit le circuit lui-même comprenant des éléments actifs et passifs incluant des lignes de transmission formées de conducteurs microrubans, et dont la seconde face reçoit un plan de masse. Dans cette technologie, la valeur des impédances est liée d'une part aux dimensions physiques des rubans, et d'autre part à l'épaisseur du substrat séparant le ruban du plan de masse. De plus, la liaison des lignes de masse, ou points de masse, de la première face avec le plan de masse de la seconde est effectuée au moyen de trous métallisés appelés VIAS (en anglais VIA HOLES). Cette technologie est particulièrement favorable à la réalisation de circuits intégrés hyperfréquences fonctionnant par exemple autour de 60 GHz ou entre 40 et 80 GHz, avec une très forte densité d'intégration.

Cette technologie doit être distinguée de la technologie dite coplanaire dans laquelle les circuits intégrés occupent une seule face d'un substrat. Dans ce cas, les lignes de transmission hyperfréquences sont réalisées au moyen de deux rubans métalliques parallèles disposés dans ce plan unique du substrat. La valeur des impédances est alors liée aux dimensions de l'un des rubans métalliques qui constitue le conducteur et à la distance séparant ce dernier de l'autre ruban relié à la masse. En technologie coplanaire, les lignes peuvent également être constituées d'un conducteur réalisé entre deux rubans de masse. Cette technologie qui comprend les conducteurs et les masses disposés sur une même face du substrat est très consommatrice de surface et donc peu propice à l'intégration à grande échelle.

C'est pourquoi, les concepteurs de circuits intégrés utilisent à ce jour, de préférence, la technologie microruban pour réaliser des circuits monolithiques hyperfréquences (MMICs, de l'anglais Monolithic Microwave Integrated Circuits).

Par le brevet japonais JP-3243871 du 21 Février 1990, il est déjà connu de réaliser un dispositif pour tester un transistor à effet de champ afin d'établir des bases de données de ses caractéristiques hyperfréquences, de manière à pouvoir l'utiliser dans la réalisation de dispositifs réalisés en technologie microruban.

A cet effet, ce document connu décrit un dispositif avec un substrat 1, comportant une première partie de ce circuit 2, et une seconde partie de circuit 3 réalisées sur une face du substrat dite supérieure.

Dans la première partie de circuit 2 est réalisé le transistor à effet de champ à tester 4 avec une zone d'entrée comprenant une grille G, une zone de masse 11 reliée à l'électrode de source S, et une zone de sortie comprenant un drain D. Les zones d'entrée et sortie sont munies de lignes de transmission 5 et 6 et de trous métallisés (VIAS) 15 reliés au plan de masse de la face inférieure du substrat. L'ensemble formé d'une extrémité de ligne disposée entre deux trous métallisés est appelé ci-après "accès". Les accès d'entrée et sortie du transisor 4 à tester se trouvent donc disposés d'une part dans la zone 7 constituée de l'extrémité 14 de la ligne 5 et des VIAS 15, et d'autre part dans une zone symétrique 8 formée de l'extrémité de la ligne 6 et de deux autres VIAS. Ainsi ces accès sont disposés, de manière symétrique, sur les bords opposés du substrat, sur la face supérieure de ce dernier, et comprennent chacun respectivement une masse - un conducteur - une masse.

Dans la seconde partie de circuit 3 est réalisé une structure de calibrage qui comprend :
- deux portions de lignes ouvertes 20 en vis-à-vis, (en anglais 0 pour open) ayant des accès masse - conducteur - masse 16 du type décrit plus haut, et alignés avec les accès 7 et 8 du transistor respectivement, aux bords du substrat ;
- deux portions de lignes chargées 22 (en anglais L pour Load) ayant des accès 18 de même type qui sont alignés avec les accès 7, 8 du transistor aux bords du substrat, ces lignes étant par ailleurs formées symétriquement en vis-à-vis l'une de l'autre. Ces lignes chargées sont constituées de tronçons de lignes microrubans de mêmes longueurs que les lignes ouvertes, dont les extrémités opposées à celles des accès comportent chacune une résistance. Ces résistances ne sont pas reliées à la masse par leur autre extrémité. L'ensemble forme donc des lignes ouvertes chargées, et la valeur des résistances ne peut pas être déterminée avec précision du fait de la configuration choisie. Toute cette partie de la structure de calibrage est donc symétrique par rapport à un axe parallèle aux bords du substrat qui passe sensiblement au niveau de la grille G du tansistor, et au milieu de la face supérieure de ce substrat.

Cette structure de calibrage comprend en outre une ligne de transmission (en anglais T pour Thru, correspondant à une ligne) de 50 Ω ayant un de ses accès 19 masse - conducteur - masse sur un des bords du substrat, et son autre accès 23, de même type, situé non pas sur l'autre bord mais dans une zone à l'intérieure de la surface supérieure du substrat.

Cette structure de calibrage forme donc un système dit SOLT (pour l'anglais Short, Open, Load, Thru) pour tests SUR-substrat (en anglais ON-WAFER) en technologie microruban (en anglais MICROSTRIP). Elle présente l'avantage du test SUR-SUBSTRAT qui évite les inconvénients à ce jour connus, des tests au moyen de structures de calibrage HORS-SUBSTRAT (OFF-WAFER).

Il faut savoir qu'un problème technique, concernant l'établissement de banques de données relatives aux différentes parties de circuits intégrés monolithiques hyperfréquences, se pose actuellement au concepteur de ces circuits.

Dans le but de diminuer les coûts de fabrication des circuits intégrés hyperfréquences, il est nécessaire d'automatiser autant que possible leur fabrication et donc de reporter les tests en fin d'assemblage. Là encore, il est souhaitable de mettre au point des techniques de test qui économisent le temps de travail normalement consacré à ces tests par un homme du métier qualifié. Cette stratégie implique la connaissance parfaite a priori des caractéristiques hyperfréquences de chaque élément actif ou passif entrant dans les structures finales des circuits, ainsi que la connaissance de la manière dont ces paramètrs varient en fonction des tolérances de fabrication, de la polarisation, ou de la disposition et proximité de ces éléments respectifs dans les circuits.

D'une manière générale, les tests sont effectués au moyen d'un appareillage appelé analyseur vectoriel automatisé dont les accès sont munis de sondes connectées par des câbles coaxiaux. Les extrémités des sondes sont du type coplanaire masse - conducteur - masse, pour un contact plan.

Pour utiliser ces sondes lors des tests, les motifs à tester doivent présenter des accès également du type masse - conducteur - masse. A cet effet, comme on a dit précédemment, dans un dispositif du type microruban, il est nécessaire de ramener les masses sur la face supérieure du substrat en utilisant des plots qui sont reliés à la face inférieure portant le plan de masse par des trous métallisés. Ainsi un dispositif réalisé en technologie microruban peut être testé au moyen de sondes réalisées en technologie coplanaire. Tel est le cas par exemple du dispositif cité au titre de l'état de la technique.

Effectuer le calibrage de l'appareil de mesure est une opération indispensable, qui consiste à permettre de ramener le plan de référence de mesure, qui serait autrement au niveau des accès de sortie-entrée de l'analyseur vectoriel, au niveau des entrée-sortie du motif sous test, par exemple un transistor à effet de champ.

Une structure de calibrage doit donc comprendre des motifs de caactéristiques connues telles que des charges, des court-circuits ou des lignes, de manière à permettre d'établir par des calculs quelle est la participation propre à l'appareil de mesure, aux câbles de connexion coaxiaux et aux sondes elles-mêmes, qui s'introduit dans la mesure des coefficients de réflexion et transmission de la matrice S des caractéristiques hyperfréquences des éléments de circuits intégrés. En mesurant donc ces coefficients pour des motifs connus, on peut éliminer cette participation par le calcul (en anglais : de-embeding) et ainsi tester les éléments de circuits intégrés avec une grande précision.

Cependant, ces mesures des coefficients réalisées sur des motifs connus doivent elles-mêmes être très précises. La précision de ces mesures préliminaires, ou de calibrage, dépend de plusieurs facteurs.

Un premier facteur très important réside dans la perfection du contact des extrémités de sondes coplanaires avec les accès des motifs de calibrage, ou des éléments sous test. Il apparaît que le dispositif décrit au titre de l'état de la technique présente à cet effet des défauts. Dans le dispositif connu, aucun contrôle du contact des sondes n'est possible. Un mauvais contact non détecté peut engendrer des pertes et du bruit de manière aléatoire dans les mesures.

Un second facteur encore plus important réside dans la perfection de la répétativité de la mise en place des extrémités de sonde vis-à-vis des accès des motifs de calibrage ou des éléments sous test. Or tout changement du recouvrement des accès d'un motif par les extrémités de sonde crée un changement d'impédance en phase et/ou en module, et donc peut entraîner de fortes erreurs de calibrage par la mesure de paramètres S erronés.

De telles erreurs de positionnement apparaissent tout particulièrement lorsque, pour mettre les extrémités des sondes en contact avec les accès des motifs de calibrage, on est amené à déplacer ces extrémités de sonde. Le dispositif décrit dans l'état de la technique cité présente précisément cet inconvénient : l'écartement des sondes doit être changé pour passer les sondes par exemple du motif court-circuit 20 d'accès 16 en bordure de substrat, au motif ligne (Thru) 23 d'accès 19, dont l'un est dans le centre du plan du substrat. De tels déplacements sont des sources d'erreurs énormes dans les mesures des coefficients de réflexion et transmission, et ils introduisent en particulier des changements de phase très important qui faussent les mesures et conduisent à des valeurs très erronées des composantes de la matrice S qui doit être finalement calculée.

Un troisième facteur réside dans l'algorithme de calcul lui-même, destiné à la détermination de la matrice S, algorithme qui est liée au nombre et à la nature des motifs de calibrage. Ainsi le dispositif connu présente l'inconvénient d'utiliser un algorithme imprécis. En effet, la nature des motifs de calibrage entraîne des réponses en amplitude et en phase des coefficients de transmissions et réflexion mesurés, en fonction de la fréquence, qui sont perturbées et donc qui conduisent à un calcul faussé de la matrice S.

Le standard court-circuit (SHORT) montre en particulier une inductance qui doit être mesurée. De même le standard ligne-ouverte (OPEN) montre une capacitance. Au fur et à mesure que la fréquence augmente la modélisation de ces standards court-circuit (SHORT) et ligne ouverte (OPEN) devient de plus en plus complexe du fait des capacitances et inductances parasites. Par ailleurs la ligne chargée (LOAD) montre également une inductance parasite, et des réflexions qui dépendent de la fréquence. De plus, la ligne (Through) conduit à une impédance caractéristique qui n'est pas purement réelle, mais montre une partie imaginaire. Cela résulte en des erreurs de détermination des différents coefficients (S₁₁, S₂₂, S₁₂, S₂₁) dans le calcul de la matrice S qui est le but du calibrage. Ainsi, avec le dispositif connu, le calibrage ne peut être fait qu'en bande étroite, et est limité en fréquence : il ne peut donc être appliqué à des fréquences aussi élevées que celle du domaine 40 à 80 GHz ; cette incapacité est due à la mauvaise définition des standards.

Un quatrième facteur réside dans le positionnement des plans de référence après calculs. Comme il a été dit précédemment, l'opération de calibrage vise à ramener les plans de référence de mesure au niveau des zones d'entrée-sortie d'un dispositif sous test c'est-à-dire très près l'un de l'autre, par exemple quelque dizaine de µm, typiquement 50 à 80 µm pour un transistor à effet de champ, alors que ces plans seraient sans cela au niveau des accès de sortie-entrée de l'analyseur vectoriel. Par cette opération de calibrage, on est censé s'affranchir (de-embeding) de la participation des sondes et des connexions de toutes sortes, y compris des connexions qui arrivent à l'élément sous test. Dans le dispositif connu, ceci n'est pas obtenu, car les plans de référence après calcul sont éloignés des zones d'entrée-sortie du transistor sous test = la distance entre ces plans est de l'ordre de 250 µm ; par conséquent une partie des connexions d'entrée-sortie de ce transistor doit être prise en compte. Cette situation est une source d'erreurs dans la mesure des caractéristiques du transistor, car elle nécessite de réaliser des calculs supplémentaires pour s'affranchir de la participation des connexions entre les plans de référence obtenus et les zones réelles d'entrée-sortie du transistor.

Dans le dispositif connu, on ne peut pas éviter cette situation. En effet, la position des plans de référence est par exemple définie par l'extrémité des lignes ouvertes (OPEN) 20. Ces dernières étant disposées en vis-à-vis, il existe un écartement minimal de l'ordre de deux à trois fois l'épaisseur du substrat ou encore 250 µm qui ne peut pas être réduit sous peine de voir apparaître des perturbations dues aux couplages électromagnétiques. Dans le dispositif connu, le même problème se pose d'ailleurs du fait de la position en vis-à-vis des charges (LOAD) 22. La position des plans de référence dans le dispositif est donc un inconvénient, car l'opération qui consiste à s'affranchir des éléments extérieurs (de-embeding) au dispositif sous test, est incomplète.

Un cinquième facteur réside dans la disposition des motifs les uns vis-à-vis des autres. D'une part la structure de calibrage comprenant les motifs doit être aussi compacte que possible pour diminuer les coûts, et d'autre part les parties de motifs doivent cependant ne pas créer de perturbations dues aux couplages électromagnétiques.

Dans le dispositif connu, pour réduire la surface occupée, des vias de masse des différents accès sont mis en commun ; ainsi, il est vrai, le dispositif connu est rendu compact par l'économie d'un via sur deux. Mais dans ce cas, un des vias d'extrémité de la ligne 23, qui se trouve non pas en bord de substrat, mais au centre de ce substrat, vient très près du motif de la charge 22. Cela ne peut pas être évité, puisque la ligne 23 est courte et que la structure est tassée par la mise en commun des vias. Néanmoins, cette disposition constitue un inconvénient, car il se produit un couplage électromagnétique entre ces motifs 22 et 23 et par conséquent des erreurs de calibrage.

Dans la disposition des motifs les uns vis-à-vis des autres, il faut aussi prendre en compte le nombre total de motifs. Dans le dispositif connu, on compte 8 motifs de calibrage, ce qui est beaucoup et occupe évidemment une grande surface résultant en une augmentation du coût de réalisation.

Un sixième facteur réside dans le procédé d'utilisation de la structure de calibrage. On a déjà cité l'importance qu'il y avait à disposer d'un dispositif pour l'utilisation duquel, on aligne les sondes de part et d'autre des bords du substrat. On peut ensuite descendre les sondes pour les appliquer sur les accès des motifs de calibrage, et à chaque mesure, seulement changer la position du substrat par une translation de valeur et direction précises. On a vu plus haut que le dispositif connu ne permettait pas ce genre d'utilisation, mais exigeait un changement de l'écartement des sondes au moins pour une mesure, celle de la ligne (Thru), ce qui résulte en des erreurs de calibrage.

Dans le procédé d'utilisation du dispositif de calibrage connu, il apparaît en outre que pendant les mesures relatives à une sonde, par exemple celle qui est positionnée sur les accès de gauche, l'autre sonde doit, soit se positionner sur les accès symétriques de droite, soit rester en l'air (ce qui est équivalent à une ligne ouverte). Dans l'une ou l'autre de ces procédures, il se produit des perturbations des mesures, dues aux couplages électromagnétiques, qui sont impossibles à quantifier. La structure de calibrage connue montre donc là encore un inconvénient.

Dans l'état actuel de la technique, un très grand nombre de circuits hyperfréquences sont réalisés en technologie microruban qui est particulièrement favorable à travailler en fréquences très élevées de l'ordre de 40 à 80 GHz et à obtenir une forte densité d'intégration.

La procédure de calibrage est une procédure qui aide à réaliser une caractérisation des éléments sous test la plus précise possible. Plus l'élément sous test est destiné à travailler à une fréquence élevée, plus les mesures sont difficiles, et néanmoins, plus elles doivent être précises.

Un but de l'invention est de fournir une structure de calibrage pour tester des éléments ou des circuits intégrés destinés à travailler dans un domaine de fréquences élevées, environ situé entre 40 et 80 GHz, et réalisés en technologie microruban.

Lorsque l'on cherche à tester des circuits réalisés en technologie microruban, il faut alors prendre en compte que les sondes actuellement disponibles sur le marché sont réalisées en technologie coplanaire et doivent donc être appliquées en contact avec une seule face du substrat du circuit sous test. Ainsi lorsqu'on applique une telle sonde de mesure à un circuit microruban, il apparaît une tansition difficile coplanaire-microruban. Comme il a été dit, cette transition comprend des trous métallisés pour retour à la masse à travers le substrat. Une tansition telle que celle-là engendre des modes parasites et seul le fait de réaliser la structure de calibrage dans la même technologie et sur le même substrat que l'élément de circuit sous test permet de s'affranchir de ces effets parasites.

C'est pourquoi, il est important de s'attacher à la conception d'une telle structure.

Un but de l'invention est aussi de fournir une structure de calibrage pour tester SUR-SUBSTRAT des circuits réalisés en technologie microruban, cette structure étant elle-même réalisée en technologie microruban.

Donc un but de l'invention est de fournir une structure de calibrage qui fournit des résultats plus précis que la structure connue de l'état de la technique.

Notamment l'invention vise à s'affranchir :
a) du mauvais positionnement des plans de référence vis-à-vis des zones d'entrée-sortie réelles de l'élément de circuit intégré sous-test ;
b) du mauvais positionnement des motifs les uns vis-à-vis des autres, de manière à ne pas payer un gain de place par des erreurs dues à des couplages indésirables ;
c) d'une mauvaise procédure d'utilisation de la structure de calibrage due à une disposition des motifs non optimisée ;
d) du manque de perfection dans la procédure de mise en contact des sondes et des accès de motifs ou d'éléments sous-test ;
e) du manque de répétativité dans cette dernière procédure.

En outre, un but de l'invention est de s'affranchir du standard SOLT, pour utiliser un algorithme de calcul plus précis.

Un autre but de l'invention est de fournir une structure de calibrage :
- plus compacte,
- travaillant dans une bande de fréquence plus large,
- et travaillant à des fréquences plus élevées que la structure connue.

Selon l'invention, un dispositif de calibrage tel que défini dans le préambule est en outre caractérisé en ce que les secondes extrémités qui sont en outre disposées sont décalées d'une série à l'autre dans le plan du substrat, par translations parallèles aux plans de référence, de manière telle que la distance entre ces extrémités décalées est égale ou supérieure à deux fois l'épaisseur du substrat et de manière telle que la distance d séparant les plans de référence est environ égale ou inférieure à trois fois l'épaisseur du substrat.

Un tel dispositif présente entre autres l'avantage suivant : comme les extrémités de lignes sont décalées d'une série de motifs à l'autre, on obtient que ces extrémités sont à une distance suffisante les unes des autres pour que les couplages électromagnétiques gênants soient évités, tout en permettant de réduire la distance qui sépare les plans de référence. De cette manière, on peut choisir exactement cette distance, qui n'est plus soumise à des contraintes technologiques, aussi petite qu'il est nécessaire. Ainsi, on peut choisir cette distance de manière à placer les plans de référence exactement en coïncidence avec les zones d'entrée-sortie d'un élément de circuit intégré sous test. Cet avantage est extrêmement important du fait que les éléments hyperfréquences intégrables, et en particulier les transistors à effet de champ présentent des distances entre zones d'entrée-sortie très inférieures à la valeur critique qui est de deux à trois fois l'épaisseur du substrat. Ainsi une grande précision de mesure est obtenue car ces plans de référence sont positionnés de telle sorte que toute participation d'éléments externes à l'élément sous test est réellement éliminée.

Dans une réalisation particulière, ce dispositif est caractérisé en ce qu'il comporte en outre une ligne de transmission de longueur telle que son premier et son second accès sont alignés respectivement avec les accès des première et seconde séries de motifs.

Dans ce cas, le dispositif présente en outre l'avantage suivant : lors du calibrage, la première sonde vient prendre contact avec les accès de la première série de motifs ou avec le premier accès de la ligne de transmission qui est aligné avec ces premiers accès, alors que la seconde sonde vient prendre contact avec les accès de la seconde série de motifs ou respectivement avec le second accès de la ligne de transmission qui est aligné avec ces seconds accès. Le calibrage peut donc être effectué sans changer l'écartement des deux sondes entre la prise de contact sur les accès des séries de motifs et la prise de contact sur les accès des extrémités de la ligne de transmission. La totalité de la procédure de calibrage peut donc être effectuée non seulement sans changer l'écartement des sondes entre deux tests, mais encore sans bouger les sondes : en effet, il suffit entre chaque mise en contact des sondes avec les accès de faire effectuer au substrat une simple translation parallèlement à l'axe d'alignement des accès (ou des plans de référence). Ainsi, une grande répétitivité des mesures est obtenue.

Dans une réalisation particulière, ce dispositif est caractérisé en ce que la première et la seconde séries de motifs sont disposées de part et d'autre de la ligne de transmission.

Dans cette réalisation, les erreurs de calibration dues à d'éventuelles couplages sont particulièrement bien évitées du fait que les distances nécessaires entre les motifs sont bien respectées. La précision du calibrage est donc particulièrement bonne.

Dans une réalisation particulière, ce dispositif est caractérisé en ce qu'il comporte unedite première et unedite seconde bandes de contact, formées chacune d'une bande conductrice, disposées respectivement en regard de la première et en regard de la seconde séries de motifs, et alignées respectivement avec les accès de la seconde et de la première série de motifs.

Ainsi, durant la procédure de calibrage, ladite première sonde est mise en contact successivement avec les accès de la première série de motifs, tandis que ladite seconde sonde est mise en contact avec ladite première bande de contact disposée en regard de la première série de motifs. Puis la procédure inverse est réalisée. Lorsqu'une sonde est disposée sur la bande de contact, cette dernière correspond à un court-circuit. La procédure décrite ci-dessus permet d'effectuer un contrôle de la qualité et de la répétativité du contact des sondes, et d'éliminer des participations et couplages électromagnétiques non quantifiables. En effet, les valeurs de mesures peuvent varier selon que les sondes sont en contact plus ou moins franc avec les bandes métalliques, et donc avec les accès. Cette éventualité est détectée et éliminée. L'utilisation défavorable des sondes en circuit ouvert est également éliminée. En outre cette structure avantageuse des bandes de contact est réalisée sans augmentation de la surface occupée par le dispositif sur le substrat.

Dans une réalisation particulière, ce dispositif est caractérisé en ce qu'il comporte au moins unedite première et au moins unedite seconde bandes de jalons disposées perpendiculairement respectivement à l'axe d'alignement des accès de la seconde série, et à l'axe d'alignement des accès de la première série de motifs, pour repérer le recouvrement de ces accès par les sondes.

L'avantage de cette réalisation est que le recouvrement des accès par les sondes peut être mesuré avec une grande précision. Ce recouvrement peut donc être très répétitif. Donc toutes les erreurs qui peuvent être très grandes, relatives à la variation du recouvrement, sont évitées.

Dans une réalisation particulière, ce dispositif est caractérisé en ce que une bande de jalons est disposée à au moins une extrémité de chacune des bandes de contact.

Cette réalisation est particulièrement avantageuse pour contrôler à la fois le recouvrement des accès et celui des bandes de contact, sans consommation supplémentaire de surface. Les mesures sont donc extrêmement répétitives du fait que le recouvrement est toujours parfaitement connu.

Dans les réalisations précédentes, ce dispositif peut être caractérisé en ce que les deux séries comportent chacune une ligne ouverte, et une ligne chargée, cette dernière étant en outre munie d'une résistance d'adaptation reliée à la masse par son autre extrémité, de telle manière que le dispositif constitue un système de calibrage selon le standard dit LRM comportant une ligne, des éléments réflecteurs, et des éléments chargés adaptés.

Dans ce cas, l'algorithme de calcul est extrêmement précis tout en utilisant peu de motifs : seulement 5 motifs contre 8 dans le dispositif connu de l'état de la technique. La structure du dispositif est donc compacte, moins coûteuse et plus favorable à l'intégration sur substrat, c'est-à-dire sur le même substrat que l'élément sous-test. La charge d'adaptation constituée par la résistance reliée à la masse par son autre extrémité élimine les réflexions dans le motif standard constitué par la ligne chargée. Le dispositif de calibrage est à la fois compatible avec les tests à fréquences très élevées, et très large bande. Tous les inconvénients liés à l'ancien standard SOLT connu de l'état de la technique sont évités.

Dans une réalisation ce dispositif est caractérisé en ce que la résistance d'adaptation est une résistance particulièrement ajustée, et/ou caractérisé en ce que la géométrie de la résistance est appropriée à minimiser la discontinuité avec la ligne d'une part et avec la masse d'autre part auxquelles elle est connectée, par exemple caractérisé en ce que la géométrie de la résistance est telle que cette dernière à la même largeur que la ligne.

Des essais ont montré que les mesures étaient encore améliorées.

Dans les réalisations précédentes, ce dispositif peut être caractérisé en ce que qu'il est réalisé au moyen de la technologie dite microruban, en ce que chaque accès est constitué d'une extrémité de ligne disposée entre deux trous métallisés écartés au pas des contacts masse - conducteur - masse des sondes, et en ce que chaque motif met un trou métallisé d'un accès en commun avec un trou métallisé de l'accès d'un motif adjacent, et en ce que les liaisons à la masse dans le dispositif ou le circuit sous test sont faites par des trous métallisés.

Dans ce cas, la technologie est adaptée à fonctionner aux fréquences très élevées requises pour l'application de l'invention. Elle permet la réalisation de circuits intégrés à grande échelle, et en particulier le dispositif de calibrage est compact et peu onéreux.

Dans une réalisation, ce dispositif est caractérisé en ce que, dans cette technologie microrubans, les trous métallisés pour le retour à la masse à travers le substrat, ont des plots hexagonaux ou ronds ou de toute géométrie propre à minimiser la discontinuité avec la ligne microruban qui y est connectée, ces plots étant disposés sur la face portant les accès, et étant éventuellement prolongés par une languette.

Ainsi, les discontinuités sont évitées, ce qui n'était pas le cas du dispositif connu de l'état de la technique où les plots étaient carrés, de section plus grande que celle des lignes.

Donc selon l'invention les mesures sont améliorées.

Dans les réalisations précédentes, ce dispositif peut être en outre caractérisé en ce que dans chaque série, la longueur x des lignes est égale ou supérieure à λ/4.

Des essais ont montré qu'il apparaissait en fonctionnement, dans les circuits du type microrubans des perturbations par rapport à la propagation en mode TEM, du fait du retour à la masse à travers le substrat, par les trous métallisés, lesquels créent une transition perturbée au niveau des accès. La longueur x des lignes est prévue pour qu'au bout de cette distance, la propagation soit à nouveau stabilisée selon le mode TEM ou quasi TEM, à la fois au niveau des accès et des plans de référence. Cette disposition permet donc d'éliminer ces perturbations.

L'invention est décrite ci-après en détail en référence avec les figures schématiques annexées dont :
- la figure 1 représente une sonde de mesure vue du dessus ;
- les figures 2a, 2b, 2c représentent vu du dessus et en coupe, une ligne en technologie microruban ;
- la figure 3 représente un exemple d'élément de circuit intégré à tester ;
- les figures 4a et 4b représentent un dispositif de calibrage vu du dessus dans des exemples de réalisation ;
- les figures 5a et 5b représentent des courbes de mesure des coefficients de réflexion et transmission obtenues avec des dispositifs de calibrage.

Un appareillage de mesure des paramètres de dispersion d'éléments de circuits intégrés hyperfréquences comporte deux sondes connectées à ses accès d'entrée et sortie. Pour un appareillage de ce type, par exemple un analyseur vectoriel automatique, les sondes sont à ce jour réalisées en technologie dite coplanaire.

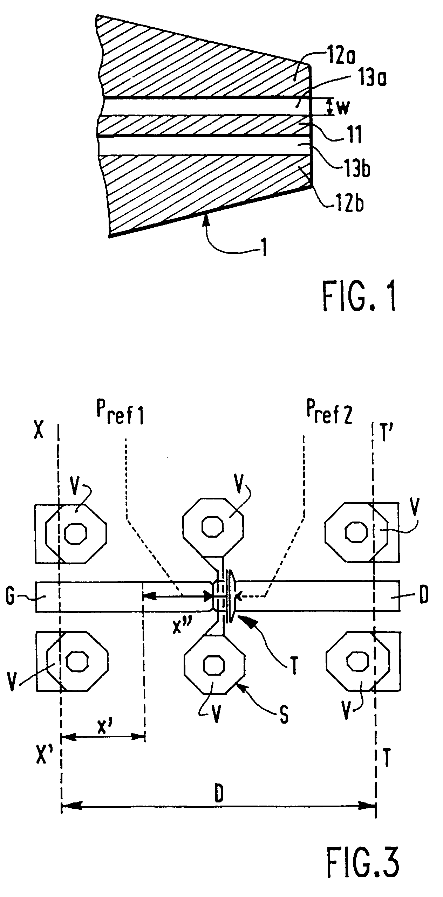

En référence avec la figure 1, les extrémités de sonde comportent, réalisés sur une même face d'un substrat 1, un conducteur central formé d'un ruban métallique 11, et au moins un ruban métallique 12a relié à la masse. En référence avec la figure 1, l'extrémité de sonde peut comporter un second ruban métallique 12b relié à la masse. Les rubans de masse 12a et 12b sont séparés du conducteur central 11, par des espacements 13a et 13b, de largeur W environ égale à l'épaisseur du substrat 1. La largeur du ruban conducteur 11 est e. L'impédance de la ligne formée par cet agencement dépend de la largeur e du ruban conducteur 11 et de la valeur W des espacements 13a et 13b.

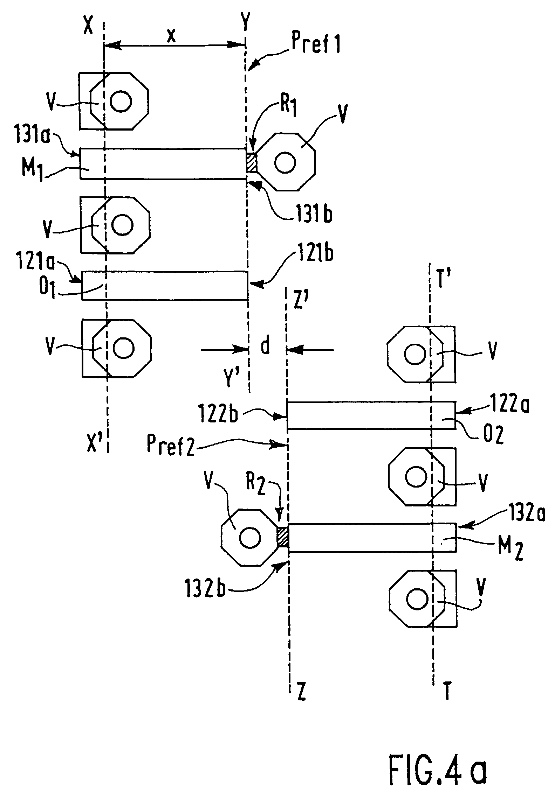

En référence avec la figure 3, on a représenté à titre d'exemple non limitatif, un transistor à effet de champ T. Ce transistor T comporte une grille, un drain et une source. Le contact de grille est prolongé par un ruban conducteur G, le contact de drain est prolongé par un ruban conducteur D, et le contact de source est relié à la masse au moyen des plots V.

Ce transistor T est réalisé en technologie dite microruban, et est destiné à être testé au moyen de l'analyseur vectoriel cité plus haut, dans le but de déterminer les paramètres de dispersion S₁₁, S₂₂, S₁₂, S₂₁ et de calculer sa matrice S.

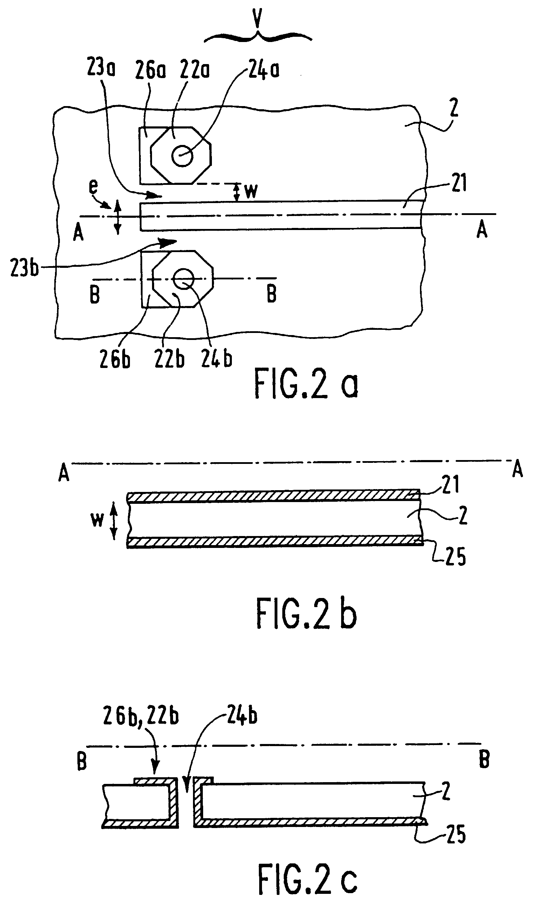

En référence avec les figures 2, une ligne réalisée en technologie microruban comporte d'une part un ruban conducteur 21 formé sur une première face, dite supérieure, d'un substrat 2, et d'autre part un plan de masse 25 formé sur la seconde face dite inférieure du substrat 2. La largeur du ruban métallique 21 est e, et l'épaisseur du substrat est W. L'impédance de la ligne dépend de la largeur e du ruban métallique 21 et de l'épaisseur du substrat W. La ligne représentée vue du dessus sur la figure 2a est par ailleurs représentée en coupe selon AA sur la figure 2b.

Dans le but de réaliser le contact entre la sonde coplanaire, telle que représentée sur la figure 1, et la ligne microruban, telle que représentée sur la figure 2a, il est nécessaire de former des contacts de masse V. Sur ladite première face ou face supérieure du substrat 2, ces contacts de masse sont réalisés en formant, à travers le substrat 2, des trous métallisés 24a, 24b pour ramener le potentiel du plan de masse 25 sur des plots de masse 22a, 22b. L'ensemble des plots de masse 22a, 22b, et des trous métallisés, respectivement 24a, 24b constituent des VIAS V.

Pour aligner les VIAS sur l'extrémité des lignes 21, dans le but de réaliser un meilleur contact avec les sondes coplanaires, on peut munir les VIAS de tronçons de rubans métalliques ou languettes 26a, 26b formés sur ladite face supérieure du substrat 2 jusqu'à l'aplomb de l'extrémité de ligne 21 par exemple.

Ainsi, on constitue avec la ligne 21 et au moins un VIA V disposé à la distance W de la ligne, un accès à cette ligne compatible à former un contact avec une sonde coplanaire. De préférence,on dispose un VIA V de part et d'autre de la ligne 21 à la distance W. La figure 2c représente une coupe selon l'axe BB d'un VIA V de la figure 2a.

La transition que l'on réalise entre la sonde coplanaire et la ligne microruban est une transition difficile qui produit des perturbations et donc des erreurs de mesure.

Ainsi en référence avec la figure 3, le transistor T sous test est muni d'un accès de grille formé de l'extrémité de la ligne G munie de deux VIAS disposés de part et d'autre de cette ligne, et d'un accès de drain formé de l'extrémité de la ligne D munie également de deux VIAS V selon la même disposition.

Du fait des perturbations dues à la transition coplanaire/microruban au niveau des accès de ligne en X'X et T'T, le mode de propagation dans les lignes G et D peut être perturbé jusqu'à une distance x' repérée à partir de ces accès, par exemple en X'X et T'T qui est environ égale à 2 à 3 fois l'épaisseur du substrat, c'est-à-dire environ 2 à 3W. Pour stabiliser le mode TEM, il faut s'assurer que la longueur de ligne entre l'accès sur X'X ou sur T'T, et les entrée-sortie de l'élément sous test sont supérieures à 2 ou 3 fois l'épaisseur du substrat.

C'est pourquoi les entrée-sortie réelles du transistor sous test sont disposées à un distance de X'X et T'T de telle sorte que x > x', par exemple x = x' + x'' de manière à ce que, entre les accès de grille et drain, et les entrée et sortie de grille et drain du transistor sous test respectivement, on puisse considérer que le mode de propagation est stabilisé selon le mode TEM ou quasi TEM.

Cependant, en référence avec la figure 3 et comme on l'a exposé plus haut, la mesure des paramètres de dispersion prend en compte les imperfections du système formé par les connexions de sonde, les sondes, la transition coplanaire-microruban et les lignes G et D jusqu'au plan P_{ref1} et P_{ref2} disposé au niveau des entrée-sortie du transistor T sous test.

Il est donc nécessaire de s'affranchir de la participation de ces éléments.

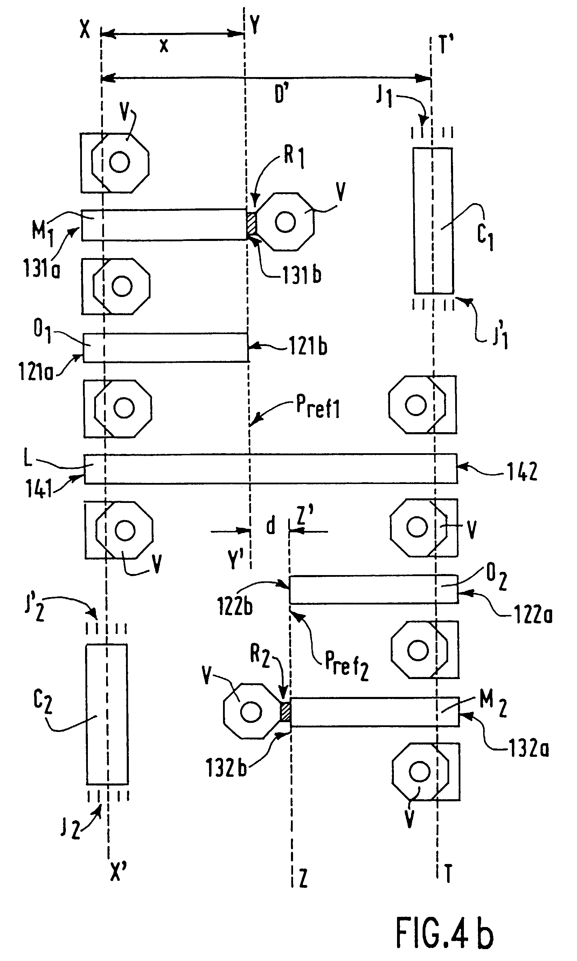

Selon l'invention, on propose à cet effet un dispositif de calibrage représenté dans des exemples de mise en oeuvre, vu du dessus, sur les figures 4a et 4b, qui permettent de ramener les plans de référence de l'appareillage, qui autrement seraient au niveau des entrée-sortie de cet appareillage, exactement en coïncidence avec les plans P_{ref1} et P_{ref2} au niveau des entrée-sortie réelles du dispositif sous test.

De préférence, le dispositif de calibrage est réalisé sur le même substrat et avec la même technologie que le dispositif sous test, donc ici en technologie microruban. Il comprend des accès pour les contacts de sonde qui sont réalisés selon la même structure.

D'une manière générale le dispositif de calibrage comprend des motifs standards et des accès à ces motifs compatibles avec les sondes de test. Les motifs standards sont prévus pour permettre la mesure de paramètres de dispersion qui permettront de s'affranchir (par le calcul) de la participation des éléments de sondes, de connexions diverses et transitions citées plus haut.

Le dispositif selon l'invention propose une disposition optimisée des motifs standards de manière à s'affranchir d'abord des inconvénients liés à la structure, qui découlaient du dispositif connu de l'état de la technique.

En référence avec la figure 4a, on a représenté vu du dessus un dispositif de calibrage qui comprend au moins deux séries identiques de motifs standards formés de lignes parallèles et de même longueur, parmi lesquelles :
- une ligne court-circuitée et/ou une ligne ouverte, et/ou une ligne chargée dont les accès sont alignés dans chaque série, mais opposés d'une série à l'autre, par rapport à la zone où sont disposées les secondes extrémités, et dont ces secondes extrémités sont alignées dans chaque série, définissant lesdits plans de référence en vis-à-vis, séparés d'une distance déterminée d, secondes extrémités qui sont en outre disposées décalées d'une série à l'autre dans le plan du substrat, par translation parallèlement aux plans de référence, de manière telle que la distance entre ces extrémités décalées est au moins égale à deux fois, et de préférence trois fois l'épaisseur du substrat 2 et de manière telle que la distance d séparant les plans de référence est égale ou inférieure à environ trois fois l'épaisseur du substrat.

Ainsi sur la figure 4a, on a représenté une première série de motifs qui comprend :
- une ligne ouverte O₁ avec une extrémité 121a munie de deux VIAS V, disposés de part et d'autre de cette extrémité formant son accès aligné sur un axe X'X, et une seconde extrémité 121b à la distance x, définie précédemment, de la première. La seconde extrémité 121b de la ligne ouverte O₁ est alignée sur l'axe Y'Y qui représente un plan de référence P_{ref1} pour le système de calibrage ;
- une ligne chargée M₁, de même longueur que la ligne ouverte O₁, ayant une première extrémité 131a alignée sur la première extrémité 121a de la ligne ouverte O₁ et son accès aligné avec celui de la ligne ouverte O₁, sur l'axe X'X, et ayant une seconde extrémité 131b, alignée sur YY' qui est en outre munie d'une résistance R₁ d'adaptation. La seconde extrémité de la résistance R₁ est portée à la masse par un VIA V, ce qui procure l'avantage de fixer la valeur de cette résistance R₁, ce qui n'était pas connu de l'état de la technique.

Dans le document cité au titre de l'état de la technique, le dispositif de calibrage comprenait une seconde série de motifs identiques à ceux d'une première série, qui étaient chacun disposés dans le prolongement les uns des autres respectivement, de sorte que les plans de référence devaient être au moins distants de deux et de préférence trois fois l'épaisseur du substrat.

Selon l'invention on a prévu une seconde série de motifs comprenant une ligne ouverte O₂ et une ligne chargée M₂ munie d'une résistance d'adaptation R₂. Les extrémités 122b et 132b de ces lignes, qui sont alignées sur l'axe Z'Z définissent le second plan de référence P_{ref2} disposé à la distance x des accès de ces lignes O₂ et M₂ qui sont alignés sur l'axe T'T, et qui sont formés des extrémités 122a et 132a de ces lignes et de VIAS V.

Selon l'invention, les extrémités 122b et 132b des lignes ne sont pas en regard des extrémités 121b et 131b respectivement, mais sont au contraire décalées par une translation parallèle aux axes X'X et T'T. Ainsi, comme montré sur la figure 4a, on a pu prévoir de diminuer la distance d qui sépare les axes Y'Y et Z'Z symbolisant les plans de référence P_{ref1} et P_{ref2} tout en maintenant entre les éléments de lignes des distances supérieures à la distance critique 3W en deça de laquelle il commence à se produire des perturbations dans la propagation dues aux couplages entre lignes.

On peut ainsi atteindre pour la distance d entre les plans de référence P_{ref1} et P_{ref2} des valeurs aussi petites que 50 à 100 µm qui permettent de faire coïncider exactement les plans P_{ref1} et P_{ref2} avec les zones d'entrée-sortie réelles d'un transistor à effet de champ intégré tel que T représenté sur la figure 3. Dans l'état de la technique, on ne pouvait descendre au-dessous de 3W qui est généralement de l'ordre de 250 µm, ce qui mettait les plans de référence dans une zone où la propagation n'est pas stabilisée selon le mode TEM, ou bien ce qui rendait les circuits de test et calibrage considérablement grands. Selon l'invention, les circuits de test et de calibrage deviennent très compacts, et surtout, la participation d'éléments extérieurs au dispositif sous test est éliminée.

En référence avec la figure 4b, de préférence, le circuit de calibrage comprend en outre une ligne de transmission L.

Lors de la procédure de calibrage, une première sonde et une seconde sonde coplanaires sont utilisées pour mesurer les paramètres de dispersions du circuit de calibrage, et à cet effet ces sondes sont posées successivement sur les accès des motifs standards, par exemple à l'alignement avec l'axe X'X pour la première sonde, et à l'alignement avec l'axe T'T pour la seconde sonde.

Pour éviter d'avoir à changer l'écartement D entre les deux sondes, durant la procédure de calibrage, la ligne L est prévue avec un premier accès du côté de son extrémité 141 aligné avec le premier axe X'X, et avec son second accès du côté de sa seconde extrémité 142 aligné avec le second axe T'T.

Ainsi dans la procédure de calibrage, on peut fixer l'écartement D des sondes, et, sans changer cet écartement du commencement à la fin de la procédure, soumettre physiquement le substrat à une translation parallèle aux axes X'X et T'T, en faisant seulement subir aux sondes le mouvement nécessaire à leur mise en contact avec les accès. Cette procédure améliore grandement la précision des mesures.

En référence avec la figure 4b, de préférence, la première et la seconde série de motifs sont disposés de part et d'autre de la ligne de transmission L.

Par cette disposition optimisée, on laisse deux parties de surface du substrat libres pour recevoir unedite première et unedite seconde bandes de contact C₁ et C₂, formées chacune d'une bande conductrice, disposées respectivement en regard de la première et en regard de la seconde séries de motifs, et alignées respectivement avec les accès de la seconde et de la première séries de motifs, c'est-à-dire sur les axes T'T et X'X respectivement.

Lors de la procédure de calibrage, la sonde non utilisée est placée en contact avec la bande de contact C₁ ou C₂ en regard du motif testé O₁ ou O₂ respectivement. La bande de contact met en court-circuit les plots masse - conducteur - masse de la sonde qu'elle reçoit, et ainsi la mesure est améliorée. Cette opération permet également d'apprécier la qualité du contact entre la sonde et les bandes métalliques.

En référence avec la figure 4b, de préférence, le dispositif de calibrage comporte deux ou un multiple de deux bandes de jalons J₁, J₂ et J'₁, J'₂ disposés respectivement perpendiculairement à l'axe d'alignement X'X et T'T des accès de chaque série de motifs, pour repérer le recouvrement des accès par les sondes. En effet des essais ont prouvé que les mesures changeaient grandement selon que les sondes sont disposées exactement sur X'X et T'T ou bien si elles recouvrent plus ou moins les accès. On constate notamment des changements dans la valeur des phases des paramètres de diffusion.

Les bandes de jalons peuvent être placées aux extrémités des bandes de contact comme sur la figure 4b, mais on peut aussi en prévoir entre les accès. Ces éléments sont extrêmement importants pour obtenir une grande précision et répétitivité des mesures.

En référence avec la figure 4b, le dispositif de calibrage qui comprend :
- une ligne L ;
- des éléments réflecteurs constitués par les lignes ouvertes O₁ et O₂ ;
- des éléments adaptés constitués par les lignes chargées M₁ et M₂ adaptées par les résistances R₁ et R₂,
appartient à un système de calibrage selon le standard dit LRM. Ce standard correspond à un algorithme de calculs extrêmement précis qui n'était pas connu en technologie microruban jusqu'à ce jour.

Pour réaliser les résistances R₁ et R₂ d'adaptation, on forme d'habitude une bande en un matériau résistif. Il sera préférable d'ajuster très finement (en anglais : trimming) la valeur de cette résistance, car on a constaté durant les essais que la précision des mesures dans le standard LRM dépendait beaucoup de l'ajustement de ces résistances R₁ et R₂. Pour ajuster ces résistances, on commence par réaliser des résistances un peu plus petites que voulu, puis à l'aide d'un masque connu de la technologie des circuits intégrés, on définit une zone dans laquelle on va diminuer l'épaisseur de la couche résistive, ce qui augmente la valeur des résistances. On obtient ainsi des résistances très finement ajustées (en anglais : trimmed resistors).

Pour mieux ajuster la valeur des résistances on peut remplacer les résistances traditionnelles par des éléments actifs montés en résistance.

Dans le cas où des résistances traditionnelles sont utilisées, la géométrie de ces résistances est choisie telle que les discontinuités avec les lignes auxquelles elles sont connectées est minimisée. Pour arriver à ce résultat, par exemple, la largeur de la résistance est choisie égale à la largeur e de la ligne.

D'une manière générale, on pourra choisir la largeur e des lignes, en fonction de l'épaisseur W du substrat, pour former des lignes de 50 Ω ou 75 Ω. Dans ce cas, les résistances R₁, R₂ pourront être également de l'ordre de 50 Ω ou 75 Ω respectivement. Une telle adaptation évite les réflexions, c'est pourquoi elle est très importante dans l'obtention de mesures précises.

En référence avec les figures 4a et 4b, pour éviter les perturbations dues aux discontinuités, aux connexions entre les plots de VIAS et les lignes, ces plots de VIAS (tels que 22a, 22b sur la figure 2a) sont prévus soit ronds, soit avec une géométrie s'approchant du rond, par exemple hexagonale, et de préférence non pas carrée comme connu de l'état de la technique. On a trouvé que cette forme hexagonale ou ronde optimisait les mesures. Cependant, il n'est pas exclu que les plots de VIAS aient une autre forme.

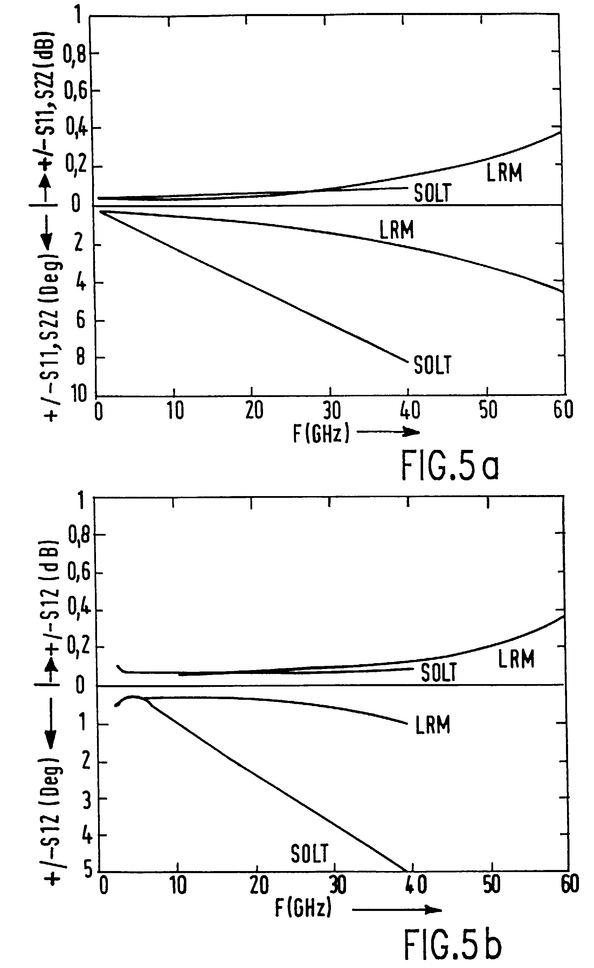

En référence avec les figures 5, on a représenté par des courbes des exemples de résultats qui peuvent être obtenus dans le cas où le système de calibrage est du type SOLT (Short, Open, Load, Thru) et dans le cas où le système de calibrage est du type LRM (Load, Reflect, Match), ce dernier cas étant prévu avec des résistances d'adaptation finement ajustées (trimmed resistors).

La figure 5a montre d'une part les réponses en amplitude (en dB) en fonction de la fréquence F (en GHz) et d'autre part les réponses en phase (en degré) en fonction de la fréquence F (en GHz) correspondant aux coefficients de dispersion S₁₁ et S₂₂. Les courbes référencées LRM représentées vis-à-vis des courbes référencées SOLT montrent que le système LRM donne des résultats à peu près équivalents au système SOLT, en amplitude, dans la mesure où la fréquence reste inférieure à 40 GHz. Ces courbes montrent en outre que le système LRM donne une réponse en phase bien meilleure dans le même domaine des fréquences inférieures à 40 GHz. Au-dessus de 40 GHz, c'est-à-dire entre 40 et 60 GHz, le système SOLT ne fournit pas de résultats, ayant atteint sa limite en fréquences, alors que le système LRM n'est pas limité. Des courbes auraient pu être tracées jusqu'à 80 GHz avec le système LRM.

La figure 5b montre, d'une part, les réponses en amplitude (en dB) en fontion de la féquence F (en GHz), et d'autre part, les réponses en phase (en degrés) en fonction de la fréquence F (en GHz) correspondant aux coefficient de dispersion S₁₂. Les courbes référencées LRM, vis-à-vis des courbes référencées SOLT, montrent que le système LRM donne ici aussi des résulats à peu près équivalents au système SOLT, en ce qui concerne l'amplitude, dans la mesure où la fréquence reste inférieure à 40 GHz, mais que ce système LRM donne une réponse en phase bien meilleure que le système SOLT dans ce domaine de fréquences. Au-dessus de 40 GHz, seul le système LRM est valide, comme il a été dit plus haut.

La structure de calibrage selon l'invention, qui comprend deux séries de motifs décalées, et qui comprend éventuellement une ligne de transmission de longueur telle que ses deux accès sont alignés avec ceux des deux séries, cette ligne de transmission étant en outre par exemple disposée entre les deux séries de motifs, a été réalisée de préférence pour les raisons exposées plus haut, en technologie microrubans.

Mais s'il en était besoin, elle pourrait très bien être réalisée en technologie coplanaire. Il suffirait pour cela de remplacer les plots de VIA par des conducteurs de masse qui seraient alors disposés entre chaque ligne. La disposition de séries de motifs décalées, avec la ligne de transmission de longueur appropriée à permettre les mesures sans déplacement des sondes est tout à fait réalisable en technologie coplanaire. Dans cette disposition, on trouve aussi la place pour les bandes de contact et les bandes de jalons, avec tous les avantages décrits plus haut.

Par ailleurs, selon l'invention, on avait trouvé avantage à réaliser les deux séries de motifs décalées, particulièrement pour rapprocher les deux plans de référence par la minimisation de la distance d.

Mais, cependant, s'il en était besoin, on pourrait très bien garder cette disposition des séries de motifs décalées, tout en adoptant une grande distance d, par exemple supérieure à trois fois l'épaisseur du substrat. On garderait alors toujours l'avantage d'avoir des emplacements pour les bandes de contact et les bandes de jalons, qui sont des éléments importants dans la qualité des mesures.

## Revendications

1. Dispositif de calibrage pour ajuster en hyperfréquences desdits plans de référence (P_{ref1}, P_{ref2}) d'un appareillage de mesure des paramètres de dispersion d'éléments de circuits intégrés sur un substrat, ce dispositif comprenant, intégrés sur ce même substrat des motifs standards et des accès à ces motifs compatibles avec les contacts de deux sondes de test connectées à l'appareillage et comprenant au moins, sur ce substrat, deux séries identiques de motifs standards formés de lignes parallèles, de même longueur et ayant une première et une seconde extrémités (131a, 121a, 122a, 132a, 131b, 121b, 122b, 132b) parmi lesquelles
une ligne court-circuitée et/ou une ligne ouverte (O₁, O₂), et/ou une ligne chargée (M₁, M₂) dont les accès sont alignés dans chaque série, mais opposés d'une série à l'autre par rapport à la zone où sont disposées les secondes extrémités (131b, 121b, 122b, 132b), et dont ces secondes extrémités sont alignées dans chaque série, définissant lesdits plans de référence (P_{ref1}, P_{ref2}) disposés en vis-à-vis, séparés d'une distance déterminée d, caractérisé en ce que les secondes extrémités qui sont en outre disposées sont décalées d'une série à l'autre dans le plan du substrat, par translations parallèles aux plans de référence (P_{ref1}, P_{ref2}), de manière telle que la distance entre ces extrémités décalées est égale ou supérieure à deux fois l'épaisseur du substrat et de manière telle que la distance d séparant les plans de référence (P_{ref1}, P_{ref2}) est environ égale ou inférieure à trois fois l'épaisseur du substrat.

2. Dispositif de calibrage selon la revendication 1, caractérisé en ce qu'il comporte en outre une ligne de transmission (L) de longueur telle que son premier et son second accès sont alignés respectivement avec les accès des première et seconde séries de motifs.

3. Dispositif de calibrage selon la revendication 2, caractérisé en ce que la première et la seconde séries de motifs sont disposées de part et d'autre de la ligne de transmission (L).

4. Dispositif de calibrage selon la revendication 3, caractérisé en ce qu'il comporte unedite première et unedite seconde bandes de contact (C₁,C₂), formées chacune d'une bande conductrice, disposées respectivement en regard de la première et en regard de la seconde séries de motifs, et alignées respectivement avec les accès de la seconde et de la première série de motifs.

5. Dispositif selon l'une des revendications 3 ou 4, caractérisé en ce qu'il comporte au moins unedite première et au moins unedite seconde bandes de jalons (J₁, J'₁, J₂, J'₂) disposées perpendiculairement respectivement à l'axe d'alignement des accès de la seconde série, et à l'axe d'alignement des accès de la première série de motifs, pour repérer le recouvrement de ces accès par les sondes.

6. Dispositif selon la revendication 5, dans la mesure où cette dernière dépend de la revendication 4, caractérisé en ce que une bande de jalons est disposée à au moins une extrémité de chacune des bandes de contact (C₁, C₂).

7. Dispositif selon l'une des revendications 1 à 6, caractérisé en ce que les deux séries comportent chacune une ligne ouverte, et une ligne chargée, cette dernière étant en outre munie d'une résistance d'adaptation (R₁, R₂) reliée à la masse par son autre extrémité, de telle manière que le dispositif constitue un système de calibrage selon le standard dit LRM comportant une ligne, des éléments réflecteurs, et des éléments chargés adaptés.

8. Dispositif selon la revendication 7, caractérisé en ce que les lignes ont des impédances caractéristiques de 50 Ω, et en ce que les résistances d'adaptation (R₁, R₂) sont de 50 Ω.

9. Dispositif selon l'une des revendications 7 ou 8, caractérisé en ce que chaque résistance d'adaptation (R₁, R₂) est une résistance particulièrement ajustée.

10. Dispositif selon l'une des revendications 8 ou 9, caractérisé en ce que la géométrie de chaque résistance (R₁, R₂) est appropriée à minimiser la discontinuité avec la ligne d'une part et avec la masse d'autre part auxquelles elle est connectée.

11. Dispositif selon la revendication 10, caractérisé en ce que la géométrie de chaque résistance (R₁, R₂) est telle que cette dernière à la même largeur que la ligne à laquelle elle est connectée.

12. Dispositif selon l'une des revendications 7 à 9, caractérisé en ce que chaque résistance d'adaptation (R₁, R₂) est constituée par un élément actif.

13. Dispositif selon l'une des revendications 1 à 12, caractérisé en ce qu'il est réalisé au moyen de la technologie dite microruban, en ce que chaque accès est constitué d'une extrémité de ligne disposée entre deux trous (V) métallisés écartés au pas des contacts masse - conducteur - masse des sondes, et en ce que chaque motif met un trou métallisé d'un accès en commun avec un trou métallisé de l'accès d'un motif adjacent, et en ce que les liaisons à la masse dans le dispositif ou le circuit sous test sont faites par des trous métallisés.

14. Dispositif selon la revendication 13, caractérisé en ce que, dans cette technologie microrubans, les trous (V) métallisés pour le retour à la masse à travers le substrat, ont des plots hexagonaux ou ronds ou de toute géométrie propre à minimiser la discontinuité avec la ligne microruban qui y est connectée, ces plots étant disposés sur la face portant les accès, et étant éventuellement prolongés par une languette.

15. Dispositif selon l'une des revendications 1 à 14,
caractérisé en ce que dans chaque série, la longueur x des lignes est égale ou supérieure à λ/4.

16. Dispositif semiconducteur intégré incluant, sur le même substrat un dispositif de calibrage et un élément de circuit intégré sous test, caractérisé en ce que le dispositif de calibrage est conforme à celui défini dans une des revendications 1 à 15, en ce que l'élément sous test présente au moins deux accès du même type que ceux du dispositif de calibrage, l'un de ces accès étant aligné avec les accès de la première série de motifs et l'autre accès étant aligné avec les accès de la seconde série de motifs, et en ce que les plans de référence du dispositif de calibrage sont prévus de telle sorte que la distance d qui les sépare coïncide au plus près avec la distance qui sépare les points de test de l'élément sous test, par exemple ses zones d'entrée sortie, et lesdits plans de référence (P_{ref1}, P_{ref2}) sont en outre disposés de telle sorte qu'ils coïncident au plus près avec lesdits points de test respectivement.

17. Procédé d'utilisation en hyperfréquences du dispositif de calibrage conforme à celui défini par l'une des revendications 4 à 15, ou du dispositif conforme à la revendication 16, au moyen d'un appareillage de mesure des paramètres de dispersion d'éléments de circuits intégrés sur le même substrat, cet appareillage étant muni de deux sondes de test, ce procédé étant mis en oeuvre de manière à ce que pendant que l'une des sondes effectue les mesures par sa mise en contact avec les accès respectifs d'une des séries de motifs, l'autre sonde est mise en contact avec la bande de contact disposée en vis-à-vis de cette série de motif et est ainsi court-circuitée pour éviter les perturbations durant les mesures.

18. Procédé d'utilisation selon la revendication 17,
caractérisé en ce que durant une mesure, l'une des sondes est mise en contact avec un accès d'un motif d'une série et l'autre sonde avec la bande de contact en vis-à-vis de la même série, ou bien chacune des sondes est mise en contact avec un des accès de la ligne de transmission, en ce que, entre deux mesures, le substrat est soumis à une translation, parallèlement aux plans de référence, d'une grandeur égale au pas de répétition des motifs, et en ce que, pour la mesure suivante, la procédure de mesure est renouvelée sans changer l'écartement des sondes du fait que la distance D séparant les accès des motifs relatifs à chacune des sondes est identique sur toute le dispositif de test et/ou de calibrage.

## Patentansprüche

1. Kalibrierungsanordnung, um bei Hyperfrequenzen Bezugsebenen (P_{ref1}, P_{ref2}) einer Meßvorrichtung für Dispersionsparameter von in einem Substrat integrierten Schaltelementen einzustellen, wobei diese Anordnung auf diesem gleichen Substrat integriert Standardmotive und Zugänge zu diesen Motiven umfaßt, die kompatibel mit den Kontakten zweier mit dem Vorrichtung verbundener Testsonden sind, und sie auf diesem Substrat zwei identische Standardmotivserien umfaßt, die aus parallelen Leitungen mit der gleichen Länge und einem ersten und einem zweiten Ende (131a, 121a, 132a, 131b, 121b, 122b, 132b) bestehen, und zwar:
eine kurzgeschlossene und/oder eine offene (O₁, O₂) Leitung, und/oder eine geladene (M₁, M₂) Leitung, deren Zugänge in jeder Serie ausgerichtet sind, aber jeweils entgegengesetzt von einer Serie zur nächsten, und deren zweite Enden (131b, 121b, 122b, 132b) in jeder Serie ausgerichtet sind und die genannten gegenüberliegend angeordneten Bezugsebenen (P_{ref1}, P_{ref2}) definieren, die zueinander einen bestimmten Abstand d haben, dadurch gekennzeichnet, daß die zweiten Enden außerdem auf der Ebene des Substrats durch parallele Translation zu den Bezugsebenen (P_{ref1}, P_{ref2}) versetzt von einer Serie zur nächsten angeordnet sind, so daß der Abstand zwischen diesen versetzten Enden wenigstens zweimal, vorzugsweise dreimal der Dicke des Substrats 2 beträgt und der Abstand d, der zwischen den Bezugsebenen (P_{ref1}, P_{ref2}) liegt, ungefähr kleiner oder gleich dreimal der Dicke des Substrats ist.

2. Kalibrierungsanordnung nach Anspruch 1, dadurch gekennzeichnet, daß sie außerdem eine Übertragungsleitung (L) mit einer solchen Länge hat, daß ihr erster und ihr zweiter Zugang mit den Zugängen der ersten bzw. zweiten Motivserie ausgerichtet sind.

3. Kalibrierungsanordnung nach Anspruch 2, dadurch gekennzeichnet, daß die erste und zweite Motivserie beiderseits der Übertragungsleitung (L) angeordnet sind.

4. Kalibrierungsanordnung nach Anspruch 3, dadurch gekennzeichnet, daß sie einen genannten ersten Kontaktstreifen und einen genannten zweiten Kontaktstreifen (C₁, C₂) umfaßt, von denen jeder einen Leiterstreifen bildet, und die vor der ersten bzw. vor der zweiten Motivserie angeordnet und mit den Zugängen der ersten bzw. der Motivserie ausgerichtet sind.

5. Anordnung nach einem der Ansprüche 3 oder 4, dadurch gekennzeichnet, daß sie wenigstens einen genannten ersten und wenigstens einen genannten zweiten Markierungsstreifen (J1, J'1, J2, J'2) umfaßt, die senkrecht zur Ausrichtungsachse der Zugänge der zweiten Serie bzw. zur Ausrichtungsachse der Zugänge der ersten Motivserie angeordnet sind, um die Abdeckung dieser Zugänge durch die Sonden anzuzeigen.

6. Anordnung nach Anspruch 5 soweit dieser von Anspruch 4 abhängig ist, dadurch gekennzeichnet, daß ein Markierungsstreifen wenigstens an einem Ende jedes Kontaktstreifens (C₁, C₂) angebracht ist.

7. Anordnung nach einem der Ansprüche 1 bis 6, dadurch gekennzeichnet, daß jede der beiden Serien eine offene Leitung und eine geladene Leitung umfaßt, wobei letztere außerdem mit einem Anpassungswiderstand (R₁, R₂) versehen ist, der durch sein anderes Ende mit Masse verbunden ist, so daß die Anordnung ein Kalibrierungssystem nach dem sogenannten LRM-Standard bildet, der eine Leitung, Reflektorelemente und eine angepaßte geladene Leitungen umfaßt.

8. Anordnung nach Anspruch 7, dadurch gekennzeichnet, daß die Leitungen charakteristische Impedanzen von 50 Ω haben und die Anpassungswiderstände (R₁, R₂) 50 Ω haben.

9. Anordnung nach einem der Ansprüche 7 oder 8, dadurch gekennzeichnet, daß jeder Anpassungswiderstand (R₁, R₂) ein besonders abgestimmter Widerstand ist.

10. Anordnung nach einem der Ansprüche 8 oder 9, dadurch gekennzeichnet, daß die Geometrie jedes Widerstandes (R₁, R₂) geeignet ist, die Diskontinuität zwischen erstens der Leitung und zweitens der Masse, mit der er verbunden ist, zu minimieren.

11. Anordnung nach Anspruch 10, dadurch gekennzeichnet, daß die Geometrie jedes Widerstandes (R₁, R₂) so ist, daß letzterer die gleiche Breite hat, wie die Leitung, mit der er verbunden ist.

12. Anordnung nach einem der Ansprüche 7 bis 9, dadurch gekennzeichnet, daß jeder Anpassungswiderstand (R₁, R₂) von einem aktiven Element gebildet wird.

13. Anordnung nach einem der Ansprüche 1 bis 12, dadurch gekennzeichnet, daß sie mittels der sogenannten Mikrobandtechnik hergestellt wird, daß jeder Zugang aus einem Leitungsende besteht, das sich zwischen zwei metallisierten Löchern (V) im Abstand des Schrittes der Kontakte Masse - Leiter - Masse befindet, und daß jedes Motiv gemeinsam mit einem metallisierten Loch des Zugangs eines angrenzenden Lochs auf ein metallisiertes Loch trifft und daß die Verbindungen mit Masse in der getesteten Anordnung oder Schaltung durch metallisierte Löcher erfolgen.

14. Anordnung nach Ansprüche 13, dadurch gekennzeichnet, daß bei dieser Mikrobandtechnik die metallisierten Löcher (V) für die Rückführung an Masse durch das Substrat hindurch, Stecker haben, die hexagonal oder rund sind oder eine sonstige Geometrie aufweisen, die geeignet ist, die Diskontinuität mit der Mikrobandleitung, die dort angeschlossen ist, zu minimieren, wobei diese Stecker auf der Seite angebracht sind, die die Zugänge enthält, und eventuell durch eine Zunge verlängert ist.

15. Anordnung nach einem der Ansprüche 1 bis 14, dadurch gekennzeichnet, daß in jeder Serie die Länge x der Leitungen gleich oder größer λ/4 ist.

16. Integrierte Halbleiteranordnung mit einer Kalibrierungsanordnung und einem getesteten integrierten Schaltungselement auf dem gleichen Substrat, dadurch gekennzeichnet, daß die Kalibrierungsanordnung einer in den Ansprüchen 1 bis 15 definierten entspricht, daß das getestete Element wenigstens zwei Zugänge vom gleichen Typ aufweist wie die Kalibrierungsanordnung, wobei einer dieser Zugänge mit den Zugängen der ersten Motivserie und der andere Zugang mit den Zugängen der zweiten Motivserie ausgerichtet ist, daß die Bezugsebenen der Kalibrierungsanordnung so vorgesehen sind, daß der Abstand d, der zwischen ihnen liegt, so genau wie möglich mit dem Abstand zusammenfällt, der zwischen den Testpunkten des getesteten Elements liegt, beispielsweise dessen Ein/Ausgangszonen, und daß die Bezugsebenen (P_{ref1}, P_{ref2}) außerdem so angeordnet sind, daß sie so genau wie möglich mit den jeweiligen genannten Testpunkten zusammenfallen.

17. Anwendungsverfahren für die Kalibrierungsanordnung wie in einem der Ansprüche 4 bis 15 definiert oder entsprechend der Anordnung nach Anspruch 16 für Hyperfrequenzen mit Hilfe einer Meßvorrichtung für Dispersionsparametern von auf dem gleichen Substrat integrierten Schaltungselementen, wobei diese Vorrichtung mit zwei Testsonden versehen ist und dieses Verfahren so ausgeführt wird, daß wenn eine der Sonden die Messungen durch Kontaktierung mit den jeweiligen Anschlüssen einer der Motivserie vornimmt, die andere Sonde in Kontakt mit dem gegenüber von dieser Motivserie liegenden Kontaktstreifen gebracht wird und dadurch kurzgeschlossen wird, um Störungen während des Messungen zu verhindern.

18. Anwendungsverfahren nach Anspruch 17, dadurch gekennzeichnet, daß während einer Messung eine der Sonden in Kontakt mit einem Zugang einer Motivserie und die andere Sonde mit dem Kontaktstreifen gegenüber dieser gleichen Serie gebracht wird, oder daß jede der Sonden in Kontakt mit einem der Zugänge der Übertragungsleitung gebracht wird, daß zwischen den Messungen mit dem Substrat eine Translation parallel zu den Bezugsebenen um eine Größe gleich dem Wiederholungsschritt der Motive vorgenommen wird, und daß für die folgende Messung, das Meßverfahren wiederholt wird, ohne den Abstand der Sonden zu verändern, da der Abstand D zwischen den Zugängen der Motive, die zu jeder der Sonden gehören, bei der gesamten Test- und/oder Kalibrierungsanordnung identisch ist.

## Claims

1. A calibration device for hyper-frequency adjustment of the reference planes (P_{ref1}, P_{ref2}) of an apparatus for measuring the dispersion parameters of elements of circuits integrated on a substrate, which device comprises, integrated on the same substrate, standard patterns and accesses to these patterns which are compatible with the contacts of two test probes connected to the apparatus, and also comprises, provided on the substrate, at least two identical series of standard patterns which are formed by parallel lines of the same length, which have a first and a second end (131a, 121a, 122a, 132a, 131b, 121b, 122b, 132b), a short-circuit line and/or an open line (O₁, O₂) and/or a load line (M₁, M₂), whose accesses are aligned within each series but opposed from one series to another with respect to the zone in which the second ends (131b,121b, 122b, 132b) are situated, their second ends being aligned within each series, defining said facing reference planes (P_{ref1}, P_{ref2}), separated by a given distance d, characterized in that the second ends which are also provided are arranged in an offset manner from one series to another in the plane of the substrate by translations parallel to the reference planes (P_{ref1}, P_{ref2}) so that the distance between these offset ends is equal to or greater than twice the thickness of the substrate and the distance d separating the reference planes (P_{ref1}, P_{ref2}) is approximately equal to or smaller than three times the thickness of the substrate.

2. A calibration device as claimed in Claim 1, characterized in that it also comprises a transmission line (L) of a length such that its first and its second access are aligned relative to the accesses of the first and the second series of patterns, respectively.

3. A calibration device as claimed in Claim 2, characterized in that the first and the second series of patterns are arranged to both sides of the transmission line (L).

4. A calibration device as claimed in Claim 3, characterized in that it comprises a so-called first and a so-called second contact strip (C₁, C₂), each of which is formed by a conductive strip provided so as to face the first and the second series of patterns, respectively, and aligned relative to the accesses of the second and those of the first series of patterns, respectively.

5. A device as claimed in one of the Claims 3 or 4, characterized in that it comprises at least one so-called first and at least one so-called second marking strip (J₁, J₁, J'₁, J₂, J'₂) which are arranged perpendicularly to the alignment axis of the accesses of the second and to the alignment axis of the accesses of the first series of patterns, respectively in order to mark the coverage of these accesses by the probes.

6. A device as claimed in Claim 5, in as far as the latter depends on Claim 4, characterized in that a marking strip is provided at least at one end of each of the contact strips (C₁, C₂).

7. A device as claimed in one of the Claims 1 to 6, characterized in that each of the two series comprises an open line and a load line, the latter line also being provided with a matching resistance (R₁, R₂) which is connected to ground *via* its other end so that the device constitutes a calibration system according to the so-called LRM standard, comprising a line, reflective elements and matched load elements.

8. A device as claimed in Claim 7, characterized in that the lines have characteristic impedances of 50 Û and in that the matching resistances (R₁, R₂) are 50 Û.

9. A device as claimed in one of the Claims 7 or 8, characterized in that each matching resistance (R₁, R₂) is a specifically adjusted resistor.

10. A device as claimed in one of the Claims 8 or 9, characterized in that the geometry of each resistance (R₁, R₂) is appropriate to minimize the discontinuity with on the one hand the line and on the other hand ground whereto it is connected.

11. A device as claimed in Claim 10, characterized in that the geometry of each resistance (R₁, R₂) is such that the latter has the same width as the line whereto it is connected.

12. A device as claimed in one of the Claims 7 to 9, characterized in that each matching resistance (R₁, R₂) is formed by an active element.

13. A device as claimed in one of the Claims 1 to 12, characterized in that it is realised by means of the so-called microstrip technology, in that each access is formed by an end of a line which is situated between two plated-through holes (V) spaced apart by the pitch of the ground-conductor-ground contacts of the probes, in that each pattern has a plated-through hole of an access in common with a plated-through hole of the access of an adjacent pattern, and in that the connections to ground in the device or the circuit being tested are realised via plated-through holes.

14. A device as claimed in Claim 13, characterized in that, in said microstrip technology, the plated-through holes (V) for return to ground through the substrate comprise pads having a hexagonal, circular or any other shape suitable for minimizing the discontinuity with the microstrip line connected thereto, said pads being provided on the face carrying the accesses and being prolonged, if necessary, by means of a strip.

15. A device as claimed in any of the Claims 1 to 14, characterized in that in each series the length x of the lines is equal to or greater than λ/4.

16. An integrated semiconductor device which includes, on the same substrate, a calibration device and an integrated circuit element being tested, characterized in that the calibration device is as claimed in one of the Claims 1 to 15, in that the element being tested comprises at least two accesses of the same type as those of the calibration device, one of said accesses being aligned relative to the accesses of the first series of patterns whereas the other access is aligned relative to the accesses of the second series of patterns, and in that the reference planes (P_{ref1}, P_{ref2}) of the calibration device are provided so that the distance d separating these planes coincides substantially with the distance separating the test points of the element being tested, for example its input/output zones, said reference planes also being provided so that they coincide as well as possible with said respective test points.

17. A method for hyper-frequency use of the calibration device as claimed in one of the Claims 4 to 15, or the device claimed in Claim 16, by means of an apparatus for measuring dispersion parameters of elements of circuits integrated on the same substrate, said apparatus being provided with two test probes, said method being implemented so that, while one of the probes performs the measurements by being brought into contact with the respective accesses of one of the series of patterns, the other probe is brought into contact with the contact strip provided so as to face said series of patterns, thus being short-circuited in order to avoid the disturbances during the measurements.

18. A method of use as claimed in Claim 17, characterized in that during a measurement one of the probes is brought into contact with an access of a pattern of a series whereas the other probe is brought into contact with the contact strip facing the same series, or each of the probes is brought into contact with one of the accesses of the transmission line, in that between two measurements the substrate is subjected to a translation, parallel to the reference planes, over a distance equal to the recurrence pitch of the patterns, and in that for the subsequent measurement the measuring procedure is renewed without changing the spacing of the probes, because the distance D separating the accesses of the patterns relative to each of the probes is identical for the entire test and/or calibration device.
